# EUROPEAN PATENT APPLICATION

(11) **EP 3 432 008 A1**
(43) Date of publication of application: **23.01.2019**
(21) Application number: 16848195.0
(22) Date of filing: 23.09.2016
(51) Int. Cl.: G01R 29/08, G01R 1/30, G01V 3/00

(54) **SYSTEM AND METHOD FOR PREVENTION AGAINST ELECTRIC DISCHARGES AND/OR ELECTRIC ARCS**

(30) Priority: 24.09.2015 ES 201531367
(71) Applicant: Consejo Superior De Investigaciones Científicas (CSIC), 28006 Madrid (ES); Charneco Fernández, Juan, 41003 Sevilla (ES); Palacios De La Olla, Ricardo, 41940 Tomares (Sevilla) (ES)
(72) Inventor: CHARNECO FERNÁNDEZ, Juan, 41003 Sevilla (ES); PALACIOS DE LA OLLA, Ricardo, 41940 Tomares (Sevilla) (ES); DELGADO RESTITUTO, Manuel, 41092 Sevilla (ES)
(74) Representative: Fernández-Pacheco, Aurelio Fernández
(86) International application number: PCT/ES2016/070668
(87) International publication number: WO 2017/051054

(57) **Abstract**

The purpose of this invention refers to a system and method of prevention against electrical discharges and / or electric arcs on individuals standing nearby an electrical installation (20). Specifically, this system comprises an actuator device (200, 200'), capable of interrupting the electrical flow of said electrical installation (20) and which is connected wirelessly with a sensor device (100) capable of wirelessly detecting electric fields emitted by the individual's body of the individual and / or by the electrical installation (20), additionally capable of indicating to the individual that the latter is at risk of suffering an electric shock and / or an electric arc.

## Description

### OBJECT OF THE INVENTION

The object of this invention relates to a prevention system and method against electric shocks and/or electric arcs to individuals who are close to an electrical installation.

This invention is based on the study of the behaviour of the electric fields surrounding a system.

More specifically, thisinvention detects the risk of electric shock or electric arc, and interrupts the electrical flow in an installation, whether low-voltage or high-voltage, before said risk materialises. Moreover, thisinvention may warn individuals about the existence of a risk of electric shock and/or electric arc.

### BACKGROUND OF THE INVENTION

Currently, various prevention systems against electric shocks and/or electric arcs are known.

One example of an electrical protection system is disclosed in the Spanish invention patent with publication number ES2029416A6. Specifically, this document describes an electronic equipment designed for the safety, electrical protection and optimisation of a power connection. Said equipment basically comprises electronic measuring, comparator and actuator circuits.

By means of these circuits, the equipment is capable of preventing sparks and explosions when a short-circuit occurs at an electrical installation, as well as autodisconnecting the load connected to the electrical installation as a result of the short-circuit, without activating the magneto-thermal breaker installed the electrical installation.

Moreover, this equipment audibly warns individuals when it detects a short-circuit or an overload in the electrical installation.

Although this document describes how to detect a short-circuit and an electrical overload, it does not prevent individuals from receiving a shock or an electric arc.

Another example of an electrical detection device is that disclosed by Spanish patent ES2259421T3. More specifically, this document describes a device designed to determine the absence, or the presence, of voltage in a single-phase or poly-phase power line with external insulation. This device is primarily designed to be used in high-voltage lines, especially those that have wire connections with voltages of the order of 1000V. Moreover, this device is equipped with a casing that contains a meter and an electronic analyser, as well as a detector head that comprises at least three measuring electrodes connected to the meter and the electronic analyser. Thus, the meter and the electronic analyser make it possible to analyse the signals received from the measuring electrodes when the latter are pressed against the external insulation of the power line.

This device may only be used when it is placed on high-voltage lines, and for a very specific use: detection of voltage in a power line. Therefore, this device only notifies of the presence or absence of electrical voltage in a power line with external insulation, but does not avoid or prevent electric shocks or arcs to individuals who are close-by or checking the power line.

On the other hand, differential automatic breakers may also be considered as background of the invention, since they interrupt the electrical flow when a person suffers an electric shock. More specifically, these differential automatic breakers are installed in every electrical installation, specifically in the corresponding electrical switchgear.

Currently, the efficiency of differential automatic breakers is very questionable, since, in order to interrupt the electrical flow, it is necessary for an individual to come into contact with the ground and a mass subjected to an electrical voltage. I.e. it requires that an electric current circulate through the individual's body towards the ground.

Moreover, these differential automatic breakers only protect individuals against contacts between a phase conductor and a grounded conductor in the electrical installation, but are completely inoperative when individuals come into direct contact with a phase conductor and a neutral conductor, or with two phase conductors.

It is worth mentioning that said phase-to-ground and phase-to-phase electrical contacts are very frequent and dangerous. This is due to the fact that, if there is no current towards the ground, the differential automatic breaker considers the individual's body to be a simple electrical receiver with an approximate resistance ranging between 1,500 and 2,000 ohms, and, therefore, does not automatically cut off the electrical flow in the electrical installation.

One example of this problem is that, in the case of electric shock due to direct contact with a phase conductor and a neutral conductor, an approximate current of 0.11 Amperes (230V / 2000 Ohms = 0.11 Amperes) circulates through the individual's body. Said amount of amperes may cause the death of a person, who cannot be saved by the differential automatic breaker, even if the latter has a sensitivity of 0.03 Amperes.

### DESCRIPTION OF THE INVENTION

This invention relates to a method system for detecting and preventing electric shocks and/or arcs to individuals who are close to an electrical installation.

The protection against electric shocks offered by this invention is based on the results of tests and measurements performed on the bodies of over 100 individuals, with different morphologies, sexes and ages, when they were in physical contact with an electrically active element, having used these results to develop a system capable of detecting the risk of electric shock before it occurs.

The results show that the body of any individual who is physically connected to an electrically active element is electrically charged and emits an electric field capable of being wirelessly detected by the system of the invention, even when no electric current flows through it.

More specifically, when an individual's body comes into physical contact with an electrically active element without external insulation that is subjected to an electric potential higher than 25 V, the body emits an electric field capable of being detected by this invention.

Moreover, when an individual's body comes into physical contact with an electrically active element with external insulation that is subjected to an electric potential higher than 100 V, the body emits an electric field capable of being detected by this invention.

In regard to the protection against electric arcs, the system of the invention is based on the results of a comparative analysis of the magnitudes of the existing electric fields to which individuals are exposed and their risk of sustaining an electric arc.

As a reference, the limit values for electric fields specified in Resolution 295/2003 of the Ministry of Labour, Employment and Social Security, on "technical specifications for ergonomics and manual handling of loads, and radiation", were used.

More specifically, the system warns individuals when the distance between their body and the elements subjected to high voltages indicates that they are exposed to electric field magnitudes equal to or higher than 15 kV/m.

Optionally, the system allows the users to set said warning to between 5 kV/m and 15 kV/m.

Moreover, the system uses a specific alert to warn individuals when they are exposed to electric field magnitudes equal to or higher than 20 kV/m, which indicates that they are at a shorter distance than that allowed and that, moreover, if this distance is reduced by a percentage that entails an imminent risk of an electric arc, the electrical flow interrupter system will be activated.

It is worth noting that the system of the invention allows for the programming of new reference values, equivalent to the new limit values for electric fields established in modified regulations.

For complete protection, thissystem is capable of interrupting the power supply under low-voltage and high-voltage conditions whenever it determines that an individual faces an imminent risk of an electric shock and/or an electric arc.

This system comprises at least one actuator device capable of interrupting the electrical flow in the electrical installation and at least one sensor device capable of wirelessly detecting electric near-fields that is wirelessly connected to the actuator device.

More specifically, an actuator device may be connected to a plurality of sensor devices. These sensor devices may be located in the area of the electrical installation and/or can be worn by individuals.

Moreover, in areas with a plurality of different electrical installations, a plurality of sensor devices connected to at least one actuator device may be used.

More specifically, the electric near-field sensor device comprises:
- at least one electric field detector antenna,
- at least one amplifier circuit connected to the detector antenna,
- at least one low-pass filter circuit connected to the amplifier circuit,
- one comparator circuit connected to the low-pass filter circuit,
- one control and command circuit connected to the comparator circuit and the amplifier circuit,
- one communication circuit connected to the comparator circuit, which is capable of sending a control signal to the actuator device,
- at least one power supply that supplies power to these circuits, and
- one enveloping insulating housing that includes at least these circuits.

Moreover, this sensor device comprises:
- an alarm circuit, connected to the comparator circuit and the control and command circuit, and
- a circuit that generates electromagnetic waves with frequencies ranging between 50 Hz and 60 Hz, with an antenna that emits electromagnetic waves, connected to the control and command circuit.

More specifically,
- the detector antenna is integrated into at least one of the outer or inner sides of the enveloping housing. Moreover, one of the outer sides of this enveloping housing is equipped with fastening means that make it possible to attach it to an individual's body or clothing, and/or even to a solid structure, such as the wall or the ceiling of a room, a table or other furniture.

Optionally, the detector antenna has incorporated means for expanding the detection area of the antenna by means of an electrical conductor element in any physical form.
- Amplifier circuit comprises a pre-amplifier, connected to the detector antenna, and a controllable-gain amplifier, connected to the pre-amplifier, the low-pass filter circuit and the control and command circuit.
- Moreover, the low-pass filter circuit comprises a low-pass filter that allows for the passage of electrical signals between 10 Hz and 100 Hz.
- Specifically, the comparator circuit comprises a first comparator circuit, connected to the control and command circuit and the communication circuit, and a second comparator circuit, connected to the control and command circuit and the alarm circuit.
- The control and command circuit comprises at least one control stage associated with a command interface that makes it possible to modify at least one of the control parameters previously programmed in the control stage.
- Moreover, the communication circuit comprises a radio transmitter which, upon being activated, transmits wireless radio signals that are communicated to the actuator device, and a transmission interface which is capable of adjusting the radio transmitter.
- The alarm circuit comprises an output stage, which is connected to the control and command circuit and at least one of the following indicator elements:
   - an acoustic indicator,
   - an optical indicator, or
   - a vibrating indicator.

Thus, the alarm circuit warns individuals when there is a risk of electric shock and/or electric arc. It is worth mentioning that the detector device may be used in an autonomous manner for all the alert functions, even when the actuator device is not operative. Finally, by means of the wave emitter antenna, the generator circuit generates a plurality of electric waves that make it possible to verify the correct detection of electric fields by the detector antenna.

Alternatively, the communication circuit of the sensor device comprises a circuit that generates and increases the amplitude of interrupter radio pulses, which is activated by means of the first comparator circuit and is connected to an emitter electrode. This configuration makes it possible to generate an interrupter radio pulse that is capacitively transmitted from the emitter electrode to the device through an individual's body and the electricity grid.

Thus, when individuals come into physical contact with an electrically active element, they transmit said interrupter radio pulse from their body to the actuator device, using the electrically active element with which they comes into contact.

It is worth mentioning that the pulse is performed for a very short time, of the order of milliseconds; i.e. the time between the moment when an individual comes into contact with the electrically active element and the moment when the actuator device disconnects the electrical installation.

Thus, the radio pulse would be the same in all the sensor devices and all the actuator devices would respond to it by interrupting the electrical flow.

Optionally, in addition to the elements previously described, the sensor device comprises:
- an additional detector antenna,
- an additional pre-amplifier connected to said additional antenna,
- an additional variable-gain amplifier connected to said additional pre-amplifier, and
- an additional low-pass filter connected to said additional amplifier.

More specifically, one of the detector antennae is integrated into one of the outer sides of the enveloping housing, whereas the other detector antenna is integrated into one of the inner sides of the enveloping housing. Moreover, each detector antenna is connected to its respective pre-amplifier, which is connected to its variable-gain amplifier and, in turn, the latter is connected to its low pass filter. Both low-pass filters are connected to the comparator circuit.

Thanks to this configuration, when connects the sensor device to the individuals or their clothing. The detector antenna on the outer side faces the electrically active elements and, therefore, detects the electric fields emitted by these elements to which the individuals are exposed, whereas the inner detector antenna detects the electric fields emitted by the individuals' bodies when they are in physical contact with an electrically active element.

Thus, when the sensor device detects an increase in the existing electric field around it, it warns individuals by means of the alarm circuit and/or transmits wireless radio signals, by means of the communication circuit, which are communicated to the actuator device in order to interrupt the electrical flow in the electrical installation.

On the other hand, the actuator device comprises:
- a radio signal receiver circuit, capable of receiving the wireless radio signals sent by the communication circuit,
- a receiver interface capable of adjusting the receiver,
- a coupling unit between the actuator device and the electrical installation,
- a switch-off circuit capable of being connected to the electrical installation,
- a safety circuit designed to verify the correct operation of the actuator device,
- an enveloping insulating housing that includes at least both circuits, and
- a power supply designed to supply all the circuits.

In one embodiment of the actuator device, it may be inserted into the switchgear of the electrical installation, this being considered to be the actuator device with a permanent configuration.

Thus, the coupling unit of the actuator device is located on one of the outer sides of the enveloping housing, which can be connected to the DIN rail of an electrical panel of the switchgear of the electrical installation or an independent electrical panel. Moreover, this body comprises at least one electrical input and one electrical output capable of being connected to the wiring of said low- or high-voltage electrical switchgear, such that it may cut off the electrical flow.

The switch-off circuit of the actuator device with a permanent configuration comprises a contactor block essentially formed by an interrupter contactor, equipped with contacts capable of being connected to the electrical installation in order to interrupt the electrical flow when the contacts are separated from one another, and a power circuit connected to the contactor block that separates or connects the contacts.

Alternatively, the switch-off circuit for a high-voltage installation comprises at least one electrical input and one electrical output capable of being connected to the turn-off switchgear of the high-voltage electrical installation itself.

At the same time, the safety circuit of the actuator device with a permanent configuration comprises a power interface connected to the power circuit, which makes it possible to check the operation of the contactor block, reset the power circuit, reset and select the type of reset.

In another embodiment of the actuator device, it may be inserted into the electrical installation by being connected to an existing AC power outlet in the electrical installation, this being considered to be the actuator device with a temporary configuration. Thus, the coupling unit is located on one of the outer sides of the enveloping housing and comprises a male power supply plug capable of being inserted into an AC power outlet of the electrical installation.

More specifically, the switch-off circuit of the actuator device with a temporary configuration comprises an electronic circuit capable of causing a ground fault of the electrical flow in the electrical installation and a controlled overcurrent of the same flow in the electrical installation, such that at least one compulsory differential automatic and/or magneto-thermal breaker of said installation will be triggered and interrupt the electrical flow.

Moreover, the actuator device, with either a permanent or temporary configuration, comprises an interrupter radio pulse receiver connected to the switch-off circuit and, therefore, capable of being connected to the electrical installation. This receiver can recognise the radio pulse sent from the sensor device and activate the switch-off circuit of the actuator device, such that it may interrupt the flow in the electrical installation.

The prevention method against electric shocks and/or electric arcs to individuals who are close to an electrical installation used by the system described above comprises the following steps:
- positioning at least one actuator device in the electrical installation,
- positioning at least one sensor device,
- selecting, by means of a command interface included in the sensor device, a mode of use for the sensor device,

- detecting, by means of a detector antenna included in the sensor device, an electric near-field,
- amplifying the signal of the electric near-field by means of an amplifier circuit,
- comparing, by means of a comparator circuit, said signal of the electric field with the alert and/or communication threshold values included in a control and command circuit,
- sending, by means of a communication circuit, a radio signal to the actuator device, such that it may prevent electrical flow in the electrical installation when any of the communication threshold values are exceeded, and
- sending, by means of an alarm circuit, an acoustic, visual or vibrating signal to the individuals who are close to the installation when any of the alert threshold values are exceeded.

Thus, depending on the positioning of the actuator device, the positioning of the sensor device and the type of electrical installation, i.e. whether the installation is low-voltage or high-voltage, individuals select a mode of use.

Each mode of use has an alert and a communication threshold value included in the control and command circuit. Thus, when the communication threshold value is reached, the sensor device sends, by means of the communication circuit, a radio signal to the actuator device, such that may interrupt the electrical flow in the electrical installation. Whereas, when the alert threshold value is reached, the sensor device warns, by means of an alarm circuit, which comprises an acoustic, visual or vibrating indicator. The individuals who are approaching the electrically active elements, or the individuals who are attempting to identify which elements close-by are electrically active.

Thus, this invention prevents against electric shock and electric arc by detecting electric fields; specifically, it makes it possible to detect the risk of electric shock when an individual comes into physical contact with an electrically active element, with or without insulation, regardless of the type of electrical contact.

Moreover, thisinvention also makes it possible to detect the risk of an electric arc when individuals approach elements subjected to high voltages, regardless of the magnitude of said high voltage.

In other words, thisinvention makes it possible to detect the electric field emitted by individuals' bodies when they come into contact with an electrically active element, as well as the electric field emitted by the electrically active element itself.

Therefore, this system makes it possible to prevent electric shocks even before they occur, as well as electric arcs, also before they occur.

It is worth mentioning that the systems known thus far only detect shocks when a connection is established, through an individual's body, between a single-phase conductor and a grounded conductor in the electrical installation, without taking into account that, currently, connections between a single-phase conductor and a neutral conductor, or between two single-phase conductors, are more frequent, due to the insulating footwear being worn. Thus, this invention protects against phase-to-phase, phase-to-neutral and phase-to-ground contacts, and may interrupt the electrical flow for any type of connection, thereby improving the reliability of the system with respect to the prior art.

This system makes it possible to interrupt the electrical flow in any electrical installation when there is contact between an individual and a non-insulated electrically active conductor and/or there is imminent risk of an electric arc, before any current circulates through the individual's body. Moreover, it warns individuals who have come into contact with an insulated electrically active conductor, or warns them that they are very close to an area of the electrical installation with a risk of an electric arc.

Optionally, in low-voltage installations, the antenna of the radio receiver of the actuator device is connected by means of an impedance adapter that adjusts the impedance of the radio circuit to the impedance of the wiring of the electrical installation wherein the actuator device is located, in order to improve communications between the communication circuit of the sensor device and the radio receiver of the actuator device, and, therefore, expand the coverage when necessary, as in large-sized low-voltage installations.

Preferably, the power supply for the sensor device is a commercially accessible battery, which may or may not be rechargeable.

Another advantage of thisinvention is that it makes it possible to connect a plurality of sensor devices that may be simultaneously used by one or several individuals to a single actuator device.

Finally, this system also makes it possible to detect, at a distance of at least 4 metres, at least one individual who comes into physical contact with a non-insulated electrically active element. Thus, when there are several individuals in the same area, they would all be protected by a single system, i.e. a sensor device and an actuator device, without the need for any additional elements.

### DESCRIPTION OF THE DRAWINGS

In order to supplement the description being made, and to contribute to a better understanding of the characteristics of the invention, according to a preferred embodiment thereof, a set of drawings is attached to said description as an integral part thereof, where the following is represented for illustrative, non-limiting purposes:
- Figure 1.-: Shows a schematic view of the electric field sensor device.
- Figure 2.-: Shows a schematic view of an embodiment of the actuator device with a permanent configuration.
- Figure 3.-: Shows a schematic view of an embodiment of the actuator device with a temporary configuration.
- Figure 4a.-: Shows a schematic view of the positioning of the sensor device on the wall of a room and its corresponding coverage area.
- Figure 4b.-: Shows a schematic view of the positioning of the sensor device on the ceiling of a room and its corresponding coverage area.
- Figure 4c.-: Shows a schematic view of the positioning of the sensor device on the wall of a room and a metallic conductor connected to the detector antenna (1), which is designed to expand the coverage thereof and, specifically, extends to the point reached by said metallic conductor element.
- Figure 5a.-: Shows a schematic view of the positioning of the sensor device on a belt.
- Figure 5b.-: Shows a schematic view of the positioning of the sensor device outside a pocket.
- Figure 5c.-: Shows a schematic view of the positioning of the sensor device inside a pocket.
- Figure 5d.-: Shows a schematic view of the positioning of the sensor device on the rear part of a safety helmet.
- Figure 5e.-: Shows a schematic view of the positioning of the sensor device on the front of a safety helmet.
- Figure 5f-: Shows a schematic view of the positioning of the sensor device on the rear part of a hat.
- Figure 5g.-: Shows a schematic view of the positioning of the sensor device on the front part of a hat.
- Figure 6.-: Shows a schematic view of the positioning of the sensor device on an individual's arm.
- Figure 7.-: Shows an embodiment of the actuator device with a permanent configuration.
- Figure 8.-: Shows an embodiment of the actuator device with a permanent configuration installed in an electrical panel.

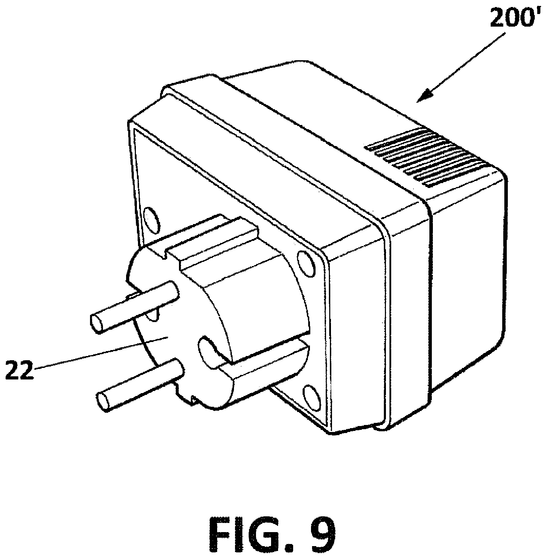

- Figure 9.-: Shows an embodiment of the actuator device with a temporary configuration.

### PREFERRED EMBODIMENT OF THE INVENTION

In a preferred embodiment of the invention, the system for preventing electric shocks and/or electric arcs to individuals who are close to an electrical installation (20) is formed by a sensor device (100) and an actuator device (200, 200') that controls the electrical flow in the electrical installation (20). Both devices comprise an enveloping insulating housing that contains the rest of the elements that make it up.

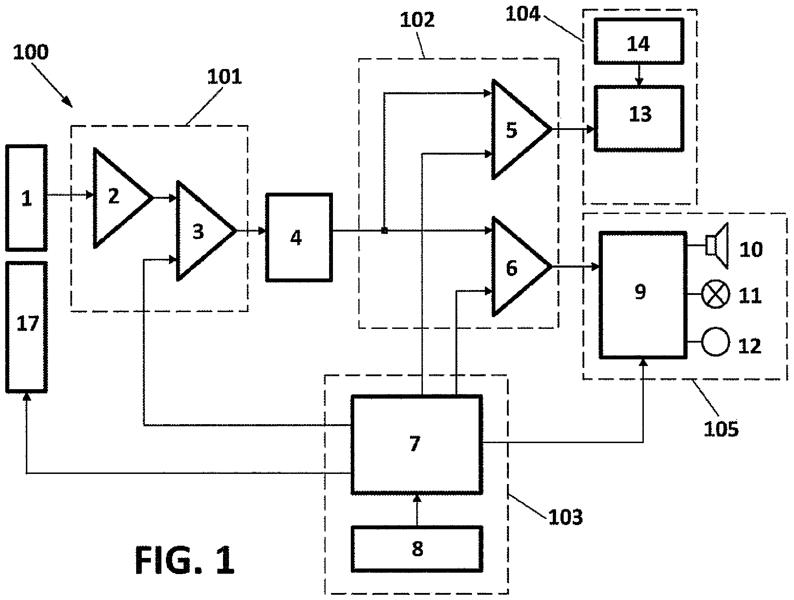

More specifically, as schematically shown in Figure 1, the sensor device (100) comprises the following in an enveloping housing:
- an electric near-field detector antenna (1) that is integrated into one of the outer sides of the enveloping housing that makes up the sensor device (100).
- a control and command circuit (103) that comprises a control stage (7) connected to a command interface (8), with which individuals may select and programme the sensor device (100).
- an amplifier circuit (101) connected to the detector antenna (1) and the control and command circuit (103), composed of a pre-amplifier (2), which amplifies the electrical signals originating from the detector antenna (1), and a controllable-gain amplifier (3), which amplifies the electrical signals originating from the pre-amplifier (2) with a gain determined by the control stage (7).
- a low-pass filter circuit (4) composed of a low-pass filter located at the output of the controllable-gain amplifier (3) of the amplifier circuit (101), which only allows for the passage of electrical signals with a frequency ranging between 10 Hz and 100 Hz.
- a comparator circuit (102) connected to the output of the low-pass filter, composed by a first comparator circuit (5) connected to a communication circuit (104), a second comparator circuit (6) connected to an alarm circuit (105), both comparators (5, 6) being connected to the control and command circuit (103).
- a communication circuit (104) that is activated by means of the first comparator circuit (5) when the communication threshold level included in the control stage (7) is exceeded, which comprises a radio transmitter (13) designed to transmit specific wireless radio signals and a transmission interface (14) that makes it possible for individuals to adjust the radio transmitter (13).
- an alarm circuit (105) connected to the comparator circuit (102) and the control and command circuit (103), designed to warn individuals about the risk of electric shock and/or electric arc. Specifically, the alarm circuit (105) comprises an output stage (9) that activates an acoustic indicator (10), an optical indicator (11) and/or a vibrating indicator (12) when the second comparator circuit (6) exceeds the alert threshold level included in said control stage (7).
- a circuit that generates electromagnetic waves (17) with frequencies ranging between 50 Hz and 60 Hz, connected to the control and command circuit (103), and comprises an incorporated emitter antenna, which operates with sequential emission levels stored in the control stage (7), in order to verify the correct detection of electric fields by the detector antenna (1) and, consequently, also verify the correct operation of the entire system.

More specifically, the detector antenna (1) is capable of:
- detecting the electric field emitted by the body of an individual to which the sensor device (100) is adapted;
- detecting, at a distance of at least 4 metres, the electric field emitted by the body of at least the individual who is included within said range;
- detecting the existing electric field in the elements subjected to high voltages to which at least the individual is exposed; and
- detecting the existing electric field in the elements subjected to low voltages that face the detector antenna (1) itself.

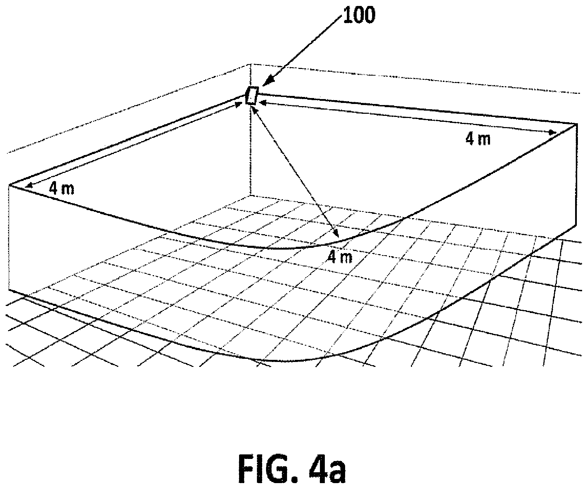

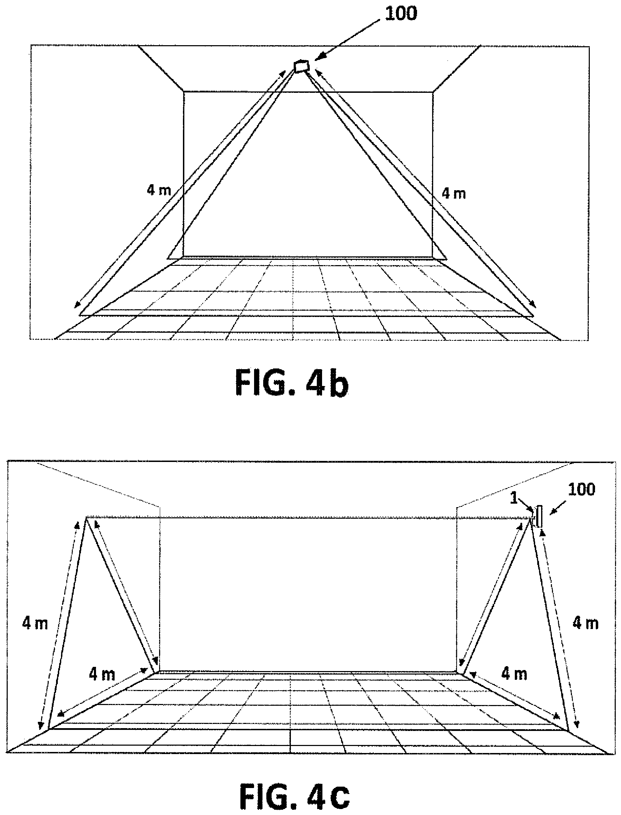

It is worth noting that the detector antenna (1) is capable of detecting, at a distance of at least 4 metres, the electric field emitted by the body of at least the individual included within said range, when the sensor device (100) is adapted to a ceiling, wall, work table or similar, as shown in Figures 4a, 4b and 4c.

More specifically, Figure 4c represents the operation of the sensor device adapted to the wall of a room and a metallic conductor element connected to the detector antenna (1), which is designed to expand the coverage thereof and, specifically, extends to the point reached by said metallic conductor element.

The control stage (7) controls the gain values of the controllable-gain amplifier (3), the communication threshold that activates the output of the first comparator circuit (5), the alert threshold that activates the output of the second comparator circuit (6), the condition of the acoustic indicator (10), the optical indicator (11) or the vibrating indicator (12), and the generator circuit (17).

Moreover, the control stage (7) includes the communication and alert threshold levels that activate the output of the first and the second comparator circuits (5, 6) for low and high voltages.

More specifically, the alert and/or communication threshold values are dependent upon at least the type of electrical installation (20), i.e. whether the installation is low-voltage or high-voltage.

In the case of low-voltage installations, the first comparator (5) activates its output and, therefore, activates the radio transmitter (13) when it detects an electric field equivalent to the electric field emitted by the body of an individual who comes into physical contact with a non-insulated element subjected to an electrical voltage greater than 50 V.

On the other hand, the second comparator (6) activates its output and, therefore, one of the indicators (10, 11, 12) through the output stage (9) when it detects an electric field equivalent to the electric field emitted by the body of an individual when it is in physical contact with a non-insulated element and subjected to an electrical voltage ranging between 25 V and 50 V.

Moreover, the second comparator (6) also activates its output when it detects the electric field emitted by the body of an individual who is in physical contact with an insulated element subjected to an electrical voltage of at least 100 V.

It is worth mentioning that, in this preferred embodiment, the sensor device (100) was used to measure the electric field emitted by a variety of individuals when they were subjected to a range of different voltages, but without any current circulating, in order to establish the alert and communication threshold values for low-voltage electrical installations.

In the case of high-voltage installations, the first comparator (5) activates its output and, therefore, activates the radio transmitter (13) when it detects an electric field emitted by an electrically active element greater than 20 kV/m by a percentage that entails an imminent risk of an electric arc.

On the other hand, the second comparator (6) activates its output and, therefore, one of the indicators (10, 11, 12) through the output stage (9) when it detects an electric field of at least 5 kV/m emitted by an electrically active element.

Optionally, the second comparator (6) also activates its output and, therefore, one of the indicators (10, 11, 12) through the output stage (9) when it detects an electric field emitted by an electrically active element that exceeds the one selected by an individual on the interface (8). Specifically, this electric field is between the preferred safety limits of 5 kV/m and 15 kV/m. Moreover, the second comparator (6) also activates its output when it detects an electric field emitted by an electrically active element with a value close to 20 kV/m. In this case, since there is a high risk of an electric arc, the output stage (9) activates, at the command of the control stage (7), all the indicators (10, 11, 12), which remain activated until the user moves away from the electrically active conductor.

Moreover, individuals may select and programme the following through the command interface (8):
- the mode of use under low-voltage or high-voltage conditions, i.e. the type of electrical installation (20) wherein the system is used,
- the maximum gain value for the controllable-gain amplifier (3), in order to use the sensor device (100) in the normal-sensitivity mode or the high-sensitivity mode,
- a variable threshold level from which the alarm circuit (105) will become activated within pre-established limits,
- the condition of the acoustic indicator (10), the optical indicator (11) or the vibrating indicator (12), and
- the activation of the circuit (17) that generates electromagnetic waves with an incorporated emitter antenna designed to verify the correct operation of the system.

More specifically, the sensor device (100) presents the following operating modes: low-voltage normal-sensitivity mode, low-voltage high-sensitivity mode and high-voltage mode. Consequently, one of the low-voltage modes is selected when individuals are close to, or about to work in, a low-voltage electrical installation, and the high-voltage mode is selected when individuals are close to, or about to work in, a high-voltage electrical installation.

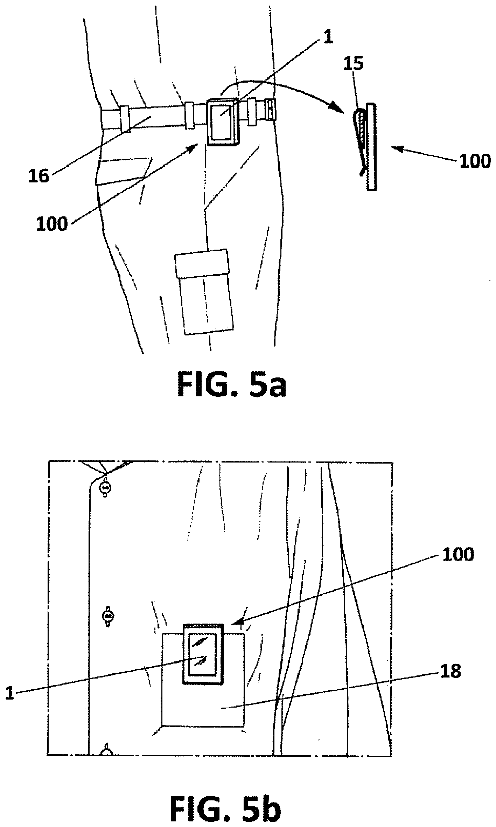

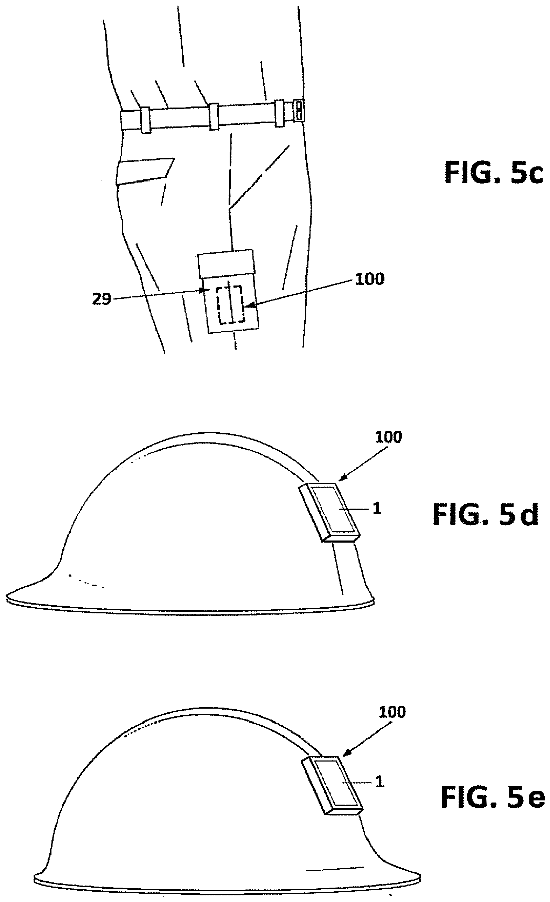

The low-voltage normal-sensitivity mode is used when individuals have the sensor device (100) connected to their clothing through fastening means, such as a clip (15), inserted into one of the outer sides of the enveloping housing, as shown in Figures 5a and 5b, specifically a shirt pocket (28) or a belt (16). Moreover, as may observed in Figure 5c, the sensor device (100) may be inside a trouser pocket (29).

Moreover, as may be observed in Figures 5d and 5e, the sensor device (100) may be positioned on a safety helmet, since the fastening means comprise an integrable male part on the casing of the enveloping housing of the sensor device (100) that fits together with an integrable female part included in a safety helmet. Alternatively, this integrable male part may fit into a safety hat or hood.

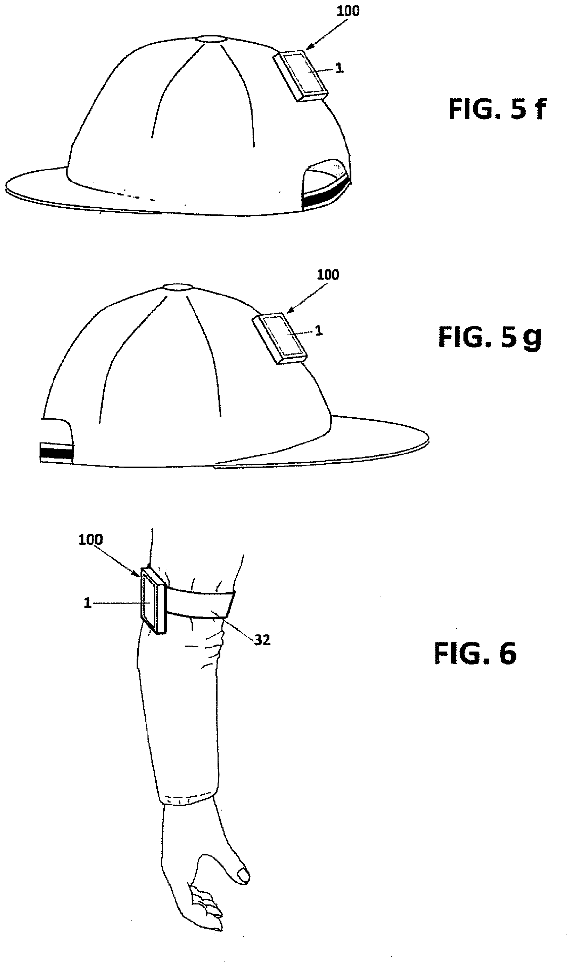

Furthermore, as may be observed in Figures 5f and 5g, the sensor device (100) may be positioned on a hat, since the fastening means comprise at least double-sided adhesive tape, Velcro adhesive tape or fastener clips that may be attached to the hat. Alternatively, they may be attached to the individuals' clothing, accessories or helmets.

Alternatively, the detector (100) may also be attached to an extremity of an individual's body by means of an elastic band (32), as shown in Figure 6.

Thus, when the low-voltage normal-sensitivity mode is selected, the sensor device (100) detects when an individual is in physical contact with an insulated or non-insulated electrically active element.

Moreover, in the low-voltage normal-sensitivity mode, individuals may place the sensor device (100) facing any element connected to a low-voltage grid, in order to determine whether this specific element is electrically active.

The low-voltage high-sensitivity mode is used when the sensor device (100) is positioned through other fastening means, such as openings capable of receiving screws for coupling to the wall or the ceiling of a room, as shown in Figures 4a and 4b. Thus, when an individual is within the range of detection of the sensor device (100), which may exceed a 4 m radius, the sensor device (100) detects, and recognises, when the individual is in physical contact with an insulated or non-insulated electrically active element.

More specifically, under low-voltage conditions, in both the high-sensitivity and low-sensitivity modes, the sensor device (100) may detect that an individual is undergoing electrical contact by comparing the electric field emitted by the individual's body, which is detected by means of said detector antenna (1), with communication threshold values programmed in the control stage (7). Moreover, it may detect that an individual is at risk of undergoing electrical contact when the alert threshold values are exceeded.

More specifically, in the low-voltage mode, in order to optimise communications by the communication circuit (104) of the sensor device (100) and the radio receiver (23) of the actuator device (200, 200'), the radio receiver circuit (23) comprises an impedance adapter that connects the radio circuit (23) to the wiring of the low-voltage electrical installation (20), adjusting the impedance of the first to the impedance of the second, in order to expand the coverage of the antenna (24).

In this way, the antenna (24) coverage increases and said communication will always be possible when users undergo electrical contact in the same electrical installation (20) wherein the actuator device (200, 200') is located.

More specifically, said impedance adapter comprises a capacitor, a resistance, a coil, a transformer, a diode, a transistor or a combination thereof.

It is worth mentioning that, optionally, each radio receiver circuit (23) is associated with an unlimited number of radio transmitters (13) by means of a specific combination of at least two simultaneous communication channels with different carrier frequencies which the radio receivers (23) recognise and identify, without taking into account any code included in the carrier signals themselves.

That is to say, the radio signals comprise a combination of at least two carrier signals with different frequencies, which make it possible for the radio receiver (23) to identify each radio transmitter (13). Thus, each radio receiver circuit (23) is associated with the corresponding radio transmitters (13) and identifies them solely and exclusively by the reception of a specific combination of at least two simultaneous communication channels with different carrier frequencies originating from them.

Moreover, the switch-off circuit of the actuator device (200, 200') is activated when the radio receiver circuit (23) simultaneously receives the combination of at least two simultaneous communication channels, emitted by any of the radio transmitters (13) associated with the radio receiver (23).

On the other hand, in the high-voltage mode, the sensor device (100) may be used to warn individuals when they begin to reduce the safety distance limit between their bodies and the elements subjected to high voltages. This distance limit is calculated by the sensor device (100) by comparing the existing emitted electric field to which the individuals' bodies are exposed at that precise moment, which are detected by means of the detector antenna (1), with alert threshold values programmed in the control stage (7). Said specific threshold values may be modified, within pre-established limits, by individuals through the command interface (8).

Furthermore, in the high-voltage mode it is also possible to interrupt the electrical flow in a high-voltage installation when individuals reduce the safety distance limit with respect to the elements subjected to high voltages by a percentage that may entail an imminent risk of an electric arc. To this end, the sensor device (100) compares the existing emitted electric field to which the individuals' bodies are exposed at that precise moment, which are detected by means of the detector antenna (1), with the communication threshold values that are programmed in the control stage (7).

In this high-voltage mode, the sensor device (100) is carried by individuals on the front part of their clothing, as shown in Figure 5b, in a shirt pocket (28) or in their hands, when they are at a large distance from elements that may be subjected to high voltages. Therefore, the sensor device (100) may detect specific elements that are electrically active, which makes it possible to prevent potential electric arcs and/or electric shocks.

In a non-limiting manner, when the detector antenna (1) detects the electric field, the electrical signals detected pass into the pre-amplifier (2) and from the latter into the controllable-gain amplifier (3), which amplifies by a gain determined by the control stage (7) on the basis of the mode of use, high-sensitivity or normal-sensitivity, selected by individuals on the command interface (8).

The electrical signals originating from the controllable-gain amplifier (3) pass into the low-pass filter, which only allows for the passage of electrical signals ranging between 10 Hz and 100 Hz. The electrical signals present in the output of the low-pass filter pass into the first comparator circuit (5), which activates the radio transmitter (13) when the transmission threshold programmed in the control stage (7) is exceeded.

The electrical signals present in the output of the low-pass filter also pass into the second comparator circuit (6), which activates the alarm circuit (105) when the alert threshold programmed in the control stage (7) is exceeded.

Therefore, when the individual undergoes electrical contact, the magnitude of the electric fields detected by the detector antenna (1) will cause the first comparator circuit (5) to activate its output and, in turn, activate the radio transmitter (13), such that it may emit specific wireless radio signals that will reach the actuator device (200, 200'), which will immediately interrupt the electrical flow.

On the other hand, when individuals are at imminent risk of sustaining an electric arc, usually in high-voltage installations, the magnitude of the electric fields to which they are exposed detected by the detector antenna (1) before said arc occurs will cause the first comparator circuit (5) to activate the radio transmitter (13), which will emit specific wireless radio signals that will instantaneously reach the actuator device (200), such that it may act on the automatic high-voltage turn-off switchgear in order to interrupt the electrical flow.

In regard to the actuator device (200, 200'), it is formed by an enveloping insulating housing that presents two configurations, a permanent configuration and a temporary configuration. I.e. a configuration capable of being installed in the electrical installation (20) in a permanent or temporary manner.

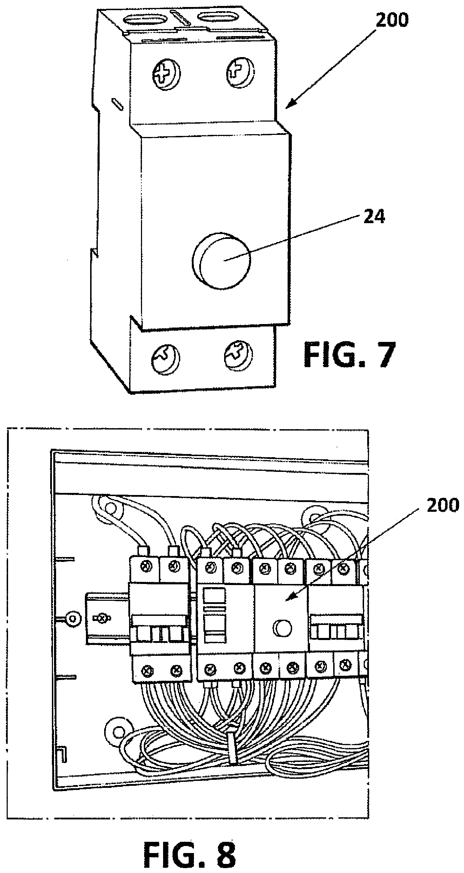

More specifically, as schematically shown in Figure 7, the actuator device (200) with a permanent configuration has, on one of the outer sides of the enveloping housing, a configuration capable of being connected to a DIN rail of an electrical panel that is a part of the switchgear of the electrical installation (20), and comprises at least one electrical input and one electrical output capable of being connected to the wiring of said electrical panel. As may be seen in Figure 8, this electrical panel is a conventional electrical panel that all low-voltage electrical installations must have installed, with a plurality of automatic breakers designed to interrupt the flow of electricity in a plurality of electrical installations.

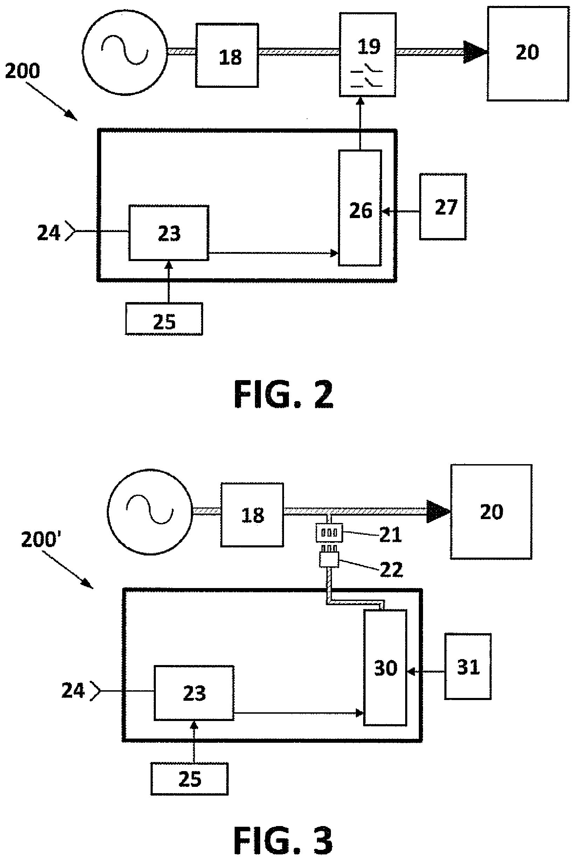

More specifically, the actuator device (200), as shown in figure 2, comprises:
- a radio receiver circuit (23) that receives the wireless radio signals emitted by the radio transmitter (13) by means of the wireless radio signal receiver antenna (24).
- a receiver interface (25) connected to the radio receiver (23), which allows for all types of programming, selection and settings on said wireless signal receiver.
- a contactor block (19), essentially formed by an interrupter contactor controlled from the power circuit (26), which interrupts the electrical flow when the contacts are opened.
- a power circuit (26) that acts on the contactor block (19) such that it may interrupt the electrical flow in the electrical installation (20).
- a power interface (27) connected to the power circuit (26), which makes it possible to test, reset and select the type of reset.

When the radio receiver circuit (23) receives, by means of the receiver antenna (24), the corresponding specific wireless radio signals originating from the radio transmitter (13), it immediately activates the power circuit (26), which acts on the contactor block (19), causing it to instantaneously interrupt the electrical flow into the electrical installation (20).

In regard to the actuator device (200') with a temporary configuration as shown in Figure 7, it has, on the outer sides of the enveloping housing, a male power supply plug (22) capable of being inserted into an AC power outlet (21) in the electrical installation (20).

More specifically, as shown in Figure 3, the actuator device (200') with a temporary configuration is composed of:
- a wireless radio signal receiver circuit (23), which receives the wireless radio signals emitted by the radio transmitter (13) by means of the wireless radio signal receiver antenna (24).
- a receiver interface (25) connected to the radio receiver (23), which allows for all types of programming, selection and settings on said wireless signal receiver.
- a ground fault and controlled overcurrent circuit (30) capable of simultaneously causing a momentary ground fault and a controlled overcurrent in the electrical installation (20), in order to cause the differential automatic and/or magneto-thermal breakers of the general panel (18) of the switchgear to be triggered and, therefore, interrupt the electrical flow.
- a ground fault interface (31) on the ground fault and controlled overcurrent circuit (30), which makes it possible to adjust and check the operation thereof.
- a male power supply plug (22) adapted to the enveloping casing of the actuator device (200'), which is designed to be inserted into any AC power outlet (21) in the electrical installation (20).

In a non-limiting manner, when the radio receiver circuit (23) receives, through the receiver antenna (24), the signals originating from the radio transmitter (13), it immediately activates the ground fault and controlled overcurrent circuit (30), such that the differential automatic and magneto-thermal breakers in the general panel (18) of the switchgear may interrupt the electrical flow. The actuator device (200, 200') is connected by means of the male power supply plug (22), which is connected to an AC power outlet (21) pertaining to said electrical installation (20).

## Claims

1. Prevention system against electrical discharges and / or electric arcs on individuals who are in the vicinity of an electrical installation (20) that comprises at least one actuator device (200, 200') capable of cutting off the electrical flow of the electrical installation (20), **characterised in that** it additionally includes at least one sensor device (100) that wirelessly detects electric fields discharged by the device's body and / or electrically active elements of the electrical installation (20), which is connected wirelessly with the actuator device (200, 200'), wherein the sensor device (100) comprises:
- at least one detector antenna (1) of electric fields,
- at least one amplification circuit (101), linked to the detector antenna (1),
- at least one band-pass filtering circuit (4), linked to the
- amplification circuit (101),
- a comparison circuit (102), linked to the filtering circuit,
- a control and command circuit (103), linked to the comparison circuit (102) and the amplification circuit (101),
- a communications circuit (104), linked to the comparison circuit (102),
- capable of sending a control signal to the actuator device (200, 200 '),
- at least one power source for electrically powering these circuits, and
- an enclosing and electrical insulating frame that includes at least these circuits.

2. System as per claim 1, **characterised in that** the sensor device (100) further comprises:
- a warning circuit (105), linked to the comparison circuit (102) and to the control and command circuit (103), and
- a generation circuit (17) for frequency electromagnetic waves comprised between 50 Hz and 60 Hz comprising an electromagnetic wave emitting antenna.

3. System as per claim 1 **characterised in that** at least the detector antenna (1) is integrated in one of the outer or inner faces of the surround frame fitted to the sensor device (100).

4. System as per claim 1, **characterised in that** the system comprises two detector antennae (1).

5. System as per claim 4, **characterised in that** one of the detector antennas (1) is integrated in one of the outer faces of the enclosing frame of the sensor device (100), and the other detector antenna (1) is integrated into one of the faces of the surrounding frame of the sensor device (100).

6. System as per claim 1, **characterised in that** the enclosing frame on at least one of its outer faces comprises fastening means.

7. System as per claim 6, **characterised in that** the fastening means comprise a one-piece male integrable part formed in the actual housing of the surrounding frame of the sensor device (100) that fits with a female integrable part comprised in a safety helmet, or cap.

8. System as per claim 6, **characterised in that** the clamping means comprise at least one double-sided adhesive tape, adhesive Velcro tape or a clasp (15) attachable to the individual's attire, accessories, cap or helmet.

9. System as per claim 6, **characterised in that** the fastening means comprise orifices capable of receiving screws to be coupled to a solid structure such as a wall, or ceiling of a room, or a piece of furniture.

10. System as per claim 1, **characterised in that** the bandpass filtering circuit (4) comprises at least one bandpass filter located between the amplification circuit (101) and the comparison circuit (102), which allows the passage of electrical signals of between 10 Hz and 100 Hz.

11. System as per claim 1, **characterised in that** the amplification circuit (101) comprises:
- a preamplifier (2), linked to the detector antenna (1),
- and an amplifier with controllable gain (3), linked to the preamplifier (2), the bandpass filter and the control and command circuit (103).

12. System as per claim 1, **characterised in that** the circuit communication (104) comprises:
- a radio transmitter (13) that when activated transmits radio wireless signals to the actuator device (200, 200 ') to interrupt the electrical flow of the electrical installation (20), and
- a transmission interface (14) that allows for the individual to adjust the
- radio-electric transmitter (13).

13. System as per claim 1, **characterised in that** the radio transmitter (13) sends a control signal to the actuator device (200, 200 ') when the value detected by the detector antenna (1) exceeds the threshold transmission value programmed in the control and command circuit (103).

14. System as per claim 1, **characterised in that** the warning circuit (105) is activated, when the value detected by the detector antenna (1) exceeds the specific warning threshold value programmed in the control and command circuit (103).

15. System as per claim 1, **characterised in that** the comparison circuit (102) comprises: an initial comparator circuit (5) linked to the bandpass filtering circuit (4), the control and command circuit (103) and to the radio transmitter (13), in in which the first comparator circuit (5) activates the communication circuit (104) so that the actuator device (200, 200 ') thus ceasing the electrical flow of the electrical installation (20) when the electric field emitted by the body of the individual is detected wirelessly via the antenna (1) and exceeds at least one transmission threshold value, programmed in the control and command circuit (103), equivalent to the level of electric field emitted by the individual's body when it comes into physical contact with an element without insulation subjected to an electrical voltage greater than 50 V.

16. System as per claim 1, **characterised in that** the comparison circuit (102) comprises:
- an initial comparator circuit (5) linked to the bandpass filtering circuit (4), the control and command circuit (103) and to the radio transmitter (13), in which the first comparator circuit (5) activates the circuit of communication (104) so that the actuator device (200, 200 ') acts on the corresponding high-voltage switchgear so that it interrupts the electrical flow of the electrical installation (20) when the electric field detected wirelessly by the antenna (1) in the elements subjected to high voltage located in front of the individual exceeds at least one transmission threshold value, programmed in the control and command circuit (103), equivalent to the level of electric field that is in place in front of the individual when the latter is at imminent risk of undergoing an electric arc.

17. System as per claims 2 and 15, **characterised in that** the comparison circuit (102) additionally comprises:
- a second comparator circuit (6) linked to the bandpass filtering circuit (4), the control and command circuit (103) and the warning circuit (105), in which the second comparator circuit (6) activates the circuit of warning (105) to warn the individual of the existence of a risk of electric shock when the electric field emitted by the body of the individual detected wirelessly via the antenna (1) exceeds at least one warning threshold, programmed in the control and command circuit (103), equivalent to the electric field emitted by an individual's body when it is in physical contact with an element without isolation and subjected to an electrical voltage between 25 V and 50 V or when it is in physical contact with an element with insulation subjected to an electrical voltage of at least 100 V.

18. System as per claims 2 and 16, **characterised in that** the comparison circuit (102) additionally comprises:
- a second comparator circuit (6) linked to the band-pass filter circuit (4), the control and command circuit (103) and the warning circuit (105), in which the second comparator circuit (6) activates the warning circuit (105) to warn the individual that he is approaching an electrically active element in high voltage and there is a risk that an electric arc will occur when the electric field detected wirelessly via the antenna (1) in the elements subjected to high voltage placed in front of the individual exceeds at least one warning threshold programmed in the control and command circuit (103).

19. System as per claim 15, **characterised in that** the control circuit and command (103) comprises a control stage (7) linked to a control interface (8) capable of allowing the individual to modify, within a security range, the warning threshold value.

20. System as per claim 1, **characterised in that** the warning circuit (105) comprises an output stage (9) linked to an acoustic indicator (10), an optical indicator (11) or a vibratory indicator (12).

21. System as per claim 1, **characterised in that** the communication circuit (104) additionally comprises a generator and elevator circuit of amplitude of interrupting radio-electric pulses, which is activated by the comparator circuit (102) and which is linked to an emitting electrode capable of transmitting to the actuator device (200, 200 ') through the body of the individual and at least one conductor of the electrical installation (20) said radio-electric interruption pulse.

22. System as per claim 1, **characterised in that** the sensor antenna (1) additionally incorporates means for extending the detection zone of the antenna by means of an electrical conductor element.

23. System as per claim 1, **characterised in that** the sensor device (100) comprises a warning circuit (105) that allows for its use for all warning functions, even if the actuator device (200, 200 ') is not operative.

24. System as per to claim 1, **characterised in that** the actuator device (200, 200 ') comprises:
- a radio receiver circuit (23), capable of receiving wireless radio signals sent by the communication circuit (104) of at least the sensor device (100),
- a reception interface (25) linked to the radio receiver circuit (23) to allow the individual to perform all kinds of programming, selection and adjustments for the reception of wireless signals,
- a coupling unit of the actuator device (200, 200 ') connected to the
- electrical installation (20),
- a disconnection circuit that may be connected to the electrical installation (20),
- a safety circuit to verify the correct operation of the actuator device (200, 200 '),
- an enclosing and electrical insulating frame that includes at least these circuits, and
- -an energy source to power all its circuits

25. System as per claim 24, **characterised in that** the coupling unit is located on one of the outer faces of the enclosing frame whose configuration is capable of being linked to a DIN rail of a general panel (18) of the switchgear of the electrical installation (20), or of an independent electrical panel and comprises less an electrical input and an output that could be linked to the wiring of said switchgear, or high voltage models to allow for the actuator device (200) to interrupt the electric flow.

26. System as per claim 25, **characterised in that** the disconnection circuit of the electrical installation (20) comprises:
- -a contactor block (19) constituted essentially by a contactor that interrupts the electric flow when it separates its contacts from each other, and
- -a power circuit (26) linked to the contactor block (19) that manages to separate or join its contacts.

27. System as per claim 25, **characterised in that** the security circuit comprises a power interface (27) linked to the power circuit (26) that allows for the checking of the contactor block operation (19), rearming the power circuit (26), rearming and selecting the type of reassembly.

28. System as per claim 24, **characterised in that** the coupling unit is located on one of the outer faces of the enclosing frame and it comprises a male current plug (22) capable of being inserted into an AC socket (21) of the electrical installation (20).

29. System as per claim 28, **characterised in that** the disconnection circuit comprises a controlled bypass and overshoot circuit (30) capable of causing a grounding of the electrical flow of the electrical installation (20) and of causing a controlled overcurrent of the same flow in the electrical installation (20), in order to obtain a differential and or magneto-thermal automatic switch of the switchgear of said installation is triggered and interrupted for the power flow.

30. System as per claim 24, **characterised in that** the actuator device (200, 200 ') comprises an interrupting radio impulse receiver linked to the disconnection circuit, capable of acknowledging the radio-electric impulse from the interruption sent through the electrical installation (20) itself and from the sensor device (100) activating said disconnection circuit so that it interrupts the flow of the electrical installation (20).

31. Method of prevention against electric shock and / or electric arcs on individuals who are close to an electrical installation (20) of which the system described in any of the previous claims makes use, **characterised in that** it comprises the following stages:
- positioning an actuator device (200, 200 ') in the electrical installation (20),
- positioning at least one sensor device (100),
- selecting by means of a control interface (8), comprised in the sensor device (100), an operational mode for the sensor device (100),
- wirelessly detecting by a detector antenna (1) comprised in the sensor device (100) a nearby electric field,
- amplify the signal of the near electric field by means of an
- amplification circuit (101),
- comparing said electrical field signal, by means of a comparison circuit (102), with threshold values comprised in a control and command circuit (103),
- sending a radio signal, via a communication circuit (104), to the actuator device (200, 200 ') so as to impede the electrical flow of the electrical installation (20) when any of the threshold values is exceeded, and
- send an acoustic, visual or vibratory signal, by means of a warning circuit (105),
- to the individual who is close to the electrical installation (20) when any of the threshold values is exceeded.

32. System as per claim 1, **characterised in that** the radio receiver circuit (23) comprises an impedance adapter that connects the radio circuit (23) to the wiring of the electrical installation (20) low voltage, adapting the impedance of the first to the impedance of the second, in order to expand the coverage of the antenna (24).

33. System as per claim 12, **characterised in that** the signals emitted by radio-electric devices comprise a combination of at least two carrier signals of different frequencies that allow for the radio receiver (23) to identify each radio transmitter (13).
